# FASCICULE DE BREVET EUROPEEN

(11) **EP 1 281 977 B1**
(45) Date de publication et mention de la délivrance du brevet: **15.09.2004**
(21) Numéro de dépôt: 02291927.8
(22) Date de dépôt: 30.07.2002
(51) Int. Cl.: G01R 29/08

(54) **Dispositif pour la mesure de debits d'absorption specifique sur un corps fântome**
Einrichtung zum Messen der spezifischen Absorptionsrate in einem Phantomkörper
Device for measuring the specific absorption rate in a phantom body

(30) Priorité: 30.07.2001 FR 0110173
(43) Date de publication de la demande: 05.02.2003
(73) Titulaire: Bouygues Telecom, 92100 Boulogne Billancourt (FR)
(72) Inventeur: Chauvin, Sébastien, 78150 Rocquencourt (FR); Veysset, Rémy, 78220 Viroflay (FR); Picard, Dominique, 78830 Bonnelles (FR)
(74) Mandataire: Le Forestier, Eric

(56) Documents cités:
- EP-A- 0 354 135
- WO-A-01/46705
- DE-A- 19 852 525
- SCHMID T ET AL: "AUTOMATED E-FIELD SCANNING SYSTEM FOR DOSIMETRIC ASSESSMENTS" IEEE TRANSACTIONS ON MICROWAVE THEORY AND TECHNIQUES, IEEE INC. NEW YORK, US, vol. 44, no. 1, 1996, pages 105-113, XP000549467 ISSN: 0018-9480

## Description

La présente invention est relative à un dispositif pour la mesure de débits d'absorption spécifique sur un corps fantôme qui simule le corps humain et qui est soumis à un champ électromagnétique.

L'invention trouve notamment avantageusement - mais non limitativement - application dans le domaine de la téléphonie mobile, pour tester les moyens d'émission/réception de terminaux de téléphonie cellulaire.

Il est classiquement connu de mesurer des débits d'absorption spécifique (SAR ou "Specific Absorption Rate" selon la terminologie anglosaxonne également utilisée) à l'intérieur de corps fantômes que l'on soumet à un champ électromagnétique et dont les propriétés diélectriques simulent celles du corps humain.

On pourra par exemple à cet égard avantageusement se référer à l'article « Automated E-field scanning system for dosimetric assessments » - IEEE Trans. MTT, Vol.44, n°1, pp105-113, Janvier 1996.

On rappelle qu'un débit d'absorption spécifique est une valeur d'énergie absorbée par unité de masse dans un corps humain soumis à un champ électromagnétique particulier.

On utilise généralement pour établir des cartographies de débits d'absorption spécifiques des sondes de mesures de champ électrique que l'on déplace à l'intérieur du corps fantôme.

Ces sondes sont par exemple constituées par un dipôle dont les brins sont reliés par l'intermédiaire d'une diode Schottky et de lignes fortement résistives à un voltmètre qui mesure la tension continue redressée par la diode, cette tension provenant du redressement des courants induits par le champ électrique haute fréquence sur les brins métalliques du dipôle.

Le niveau de cette tension est toutefois très bas, du fait notamment des pertes de conversion.

En particulier, la forte résistivité des lignes qui relient le dipôle au voltmètre - si elle permet de réduire les effets parasites - augmente fortement le niveau du bruit.

Ainsi, dans le cas de la sonde NARDA 8021C, la résistance des lignes de connexion est de 0,5MΩ.

Il en résulte une tension de détection qui est typiquement de l'ordre de 1mV pour un champ électrique de 20V/m et de 2,5µV pour un champ électrique de 1V/m.

Dans la pratique, si l'on prend en compte les signaux parasites dus au bruit ambiant, la dérive de l'amplificateur, l'électricité statique de l'environnement, la tension du neutre, etc., il devient très difficile de mesurer des champs électriques en dessous de 10V/m.

Un but de l'invention est de résoudre ce problème.

L'invention propose quant à elle une solution qui permet d'augmenter d'un facteur 10 (voir supérieur) la sensibilité de détection.

Notamment, elle propose un dispositif pour la mesure de débits d'absorption spécifique sur un corps fantôme qui simule le corps humain et qui est soumis à un champ électromagnétique, ce dispositif comportant une sonde pour la mesure du champ électrique, un corps fantôme dans lequel ladite sonde est déplacée, des moyens pour mesurer la tension en sortie de ladite sonde. Dans ce dispositif, ces moyens de mesure comportent des moyens de détection synchrone qui mélangent un signal correspondant à la tension en sortie de ladite sonde avec un signal de référence qui est synchrone de la modulation d'amplitude du champ électromagnétique que l'on teste, les moyens de mesure comportant en outre des moyens pour mettre en oeuvre une mesure sur le signal redressé ainsi obtenu.

Dans un mode de réalisation avantageux, le dispositif comporte des moyens de réception du champ électromagnétique testé, ainsi que des moyens pour la récupération d'un signal d'horloge synchronisé sur une enveloppe de modulation dudit champ électromagnétique.

Notamment, dans le cas où le champ électromagnétique est celui émis par un terminal téléphonique d'un réseau cellulaire à multiplexage temporel, le dispositif comporte avantageusement des moyens de réception du champ électromagnétique ainsi généré, ainsi que des moyens pour la récupération d'un signal d'horloge synchronisé sur l'enveloppe de multiplexage temporel dudit champ électromagnétique.

En variante, il peut également être prévu que les moyens de détection synchrone comportent un émulateur pour la génération d'un signal de référence.

De préférence également, le dispositif comporte un amplificateur faible bruit qui est interposé entre la sonde et les moyens de détection synchrones.

Avantageusement encore, il comporte un convertisseur analogique/numérique qui reçoit le signal en sortie des moyens de détection synchrone, le signal converti en sortie dudit convertisseur étant transmis à une unité de traitement et de gestion qui relèvent et mémorisent les valeurs des mesures et déterminent en fonction des mesures qu'elle relève des cartographies de champ électrique dans le corps fantôme.

D'autres caractéristiques et avantages de l'invention ressortiront encore de la description qui suit, laquelle est purement illustrative et non limitative et doit être lue en regard des figures annexées sur lesquelles :
- la figure 1 représente schématiquement un banc de mesure conforme à un mode de réalisation possible de l'invention ;
- les figures 2a et 2b, ainsi que 3a et 3b illustrent des résultats obtenus avec d'une part un banc de mesure classique et d'autre part un banc de mesure conforme à un mode de réalisation possible de l'invention.

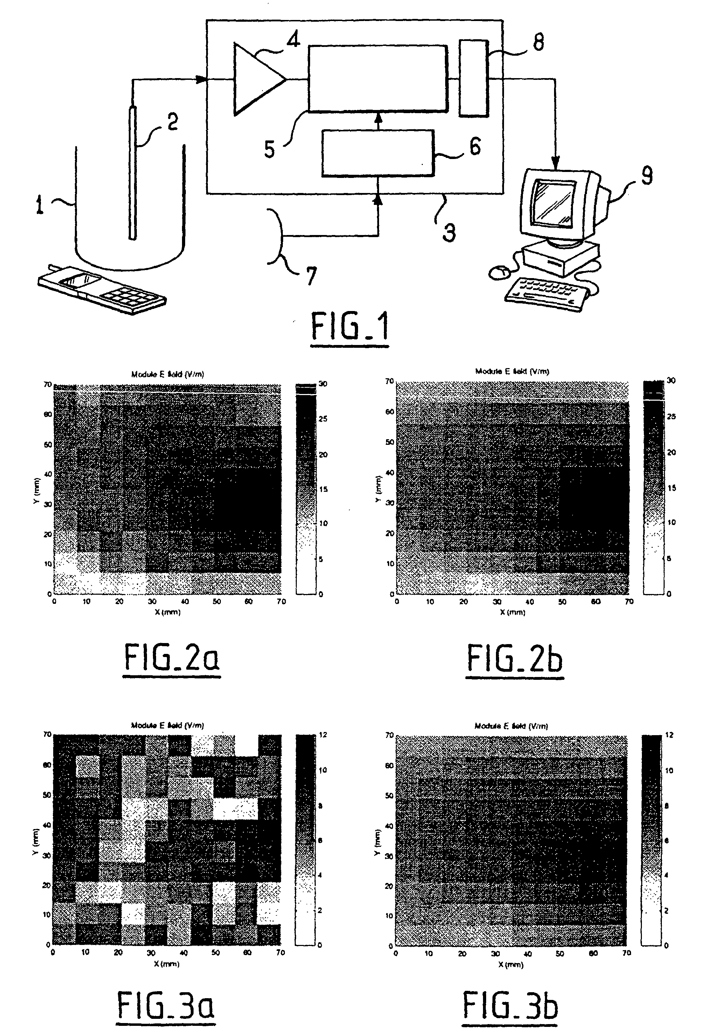

Le banc de mesure illustré sur la figure 1 comporte un corps fantôme 1 et une sonde de détection 2 qui est mobile dans celui-ci.

Le corps fantôme 1 est par exemple constitué par une poche remplie d'un liquide ayant des propriétés équivalentes à celles du corps humain, notamment quant à sa constante diélectrique et sa conductivité.

Ce corps 1 est disposé dans le champ électromagnétique dont on souhaite tester l'absorption dans le corps humain. Par exemple, dans le cas où l'on souhaite tester l'absorption du champ électromagnétique générée par un téléphone portable TP, celui-ci sera disposé à proximité immédiate du corps 1, dans une position parfaitement définie par rapport à celui-ci

La sonde 2 est une sonde de détection du champ électrique, par exemple une sonde du type de celles commercialisées par la société Narda sous la dénomination 8021 C.

La position de cette sonde de détection 2 dans la poche 1 est contrôlée par des moyens robotisés (non représentés) qui sont aptes à déplacer ladite sonde 2 dans ladite poche 1 à la fois horizontalement et verticalement.

Le pas de déplacement peut être de 5 mm ou inférieur.

Ces moyens robotisés permettent également de contrôler l'orientation de la sonde 2 dans la poche 1.

Ils sont commandés par une unité de traitement qui est par exemple celle destinée à mémoriser les mesures réalisées pour les différentes positions et à établir des cartographies à partir de ces différentes mesures (unité de traitement référencée par 9 sur la figure 1).

La sonde 2 est reliée par une ligne résistive à un ensemble qui constitue une interface 3 interposée entre d'un part ladite unité de traitement 9 et d'autre part la sonde 2.

Cette interface 3 comporte un amplificateur faible bruit 4 qui reçoit en entrée le signal de tension en sortie de la sonde 2,

Elle comporte en outre un module 5 de détection synchrone qui reçoit d'une part le signal en sortie de l'amplificateur 4 et d'autre part également un signal de référence qui est de même fréquence que le découpage que peut présenter le signal en sortie de l'amplificateur 4 et qui est cohérent avec celui-ci, le module 5 mélangeant l'un et l'autre de ces deux signaux

Par exemple, dans le cas où le signal émis par le téléphone portable est un signal à multiplexage temporel, on prévoit avantageusement au niveau de l'interface 3 un module 6 pour la récupération d'un signal d'horloge synchronisé avec l'enveloppe de modulation temporelle des signaux émis par le téléphone.

Ce module 6 de récupération de signal d'horloge est lors relié à une antenne pour la réception de signaux hertzien qui lui transmet les signaux émis par le téléphone.

En variante, il peut également être prévu que le signal qui est transmis en entrée du module 6 pour constituer le signal de référence soit un signal issu d'un émulateur de station de base de radiotéléphonie mobile.

Le signal de référence est par exemple un signal rectangulaire symétrique (c'est à dire de rapport cyclique 1/2) et réglable en retard par rapport au signal de modulation du champ électromagnétique.

Le système est ainsi transparent.

Le signal redressé qui est obtenu en sortie du module 5 est ensuite transmis à un convertisseur analogique/numérique 8 avant d'être envoyé sur une entrée de l'unité de traitement.

Celle-ci met alors en oeuvre sur le signal qu'elle reçoit des traitement d'acquisition et de génération de cartographies qui sont en eux-mêmes classiquement connus.

Des mesures ont été réalisées à partir d'un tel banc de mesure avec des téléphones portables émettant de 900MHz à 1800MHZ.

Le corps fantôme 1 avait une forme d'hémisphère.

La reproductibilité de la mesure de champ a été testée en comparant les résultats obtenus, à partir de la même disposition téléphone/fantôme, pour des séquences d'acquisition répétées, séparées dans le temps de 15 minutes, à différentes vitesses d'acquisition.

Le niveau de champ équivalent au bruit était de l'ordre de 1,1V/m pour des vitesses de mesure de 5 échantillons/seconde et de 0,75V/m pour une vitesse de mesure de 1 échantillon/seconde.

Quatre séries successives de mesures ont été réalisées pour un même téléphone disposé dans une position donnée par rapport au corps fantôme.

Chaque mesure de débit d'absorption a été réalisée sur une durée de 15 minutes.

Les résultats obtenus sont ceux présentés ci-dessous.

Ces résultats mettent une reproductibilité de mesure meilleure que 1 mW/kg.

**Table 1**

| Mesures | 1 | 2 | 3 | 4 | Ecart-type |
|---|---|---|---|---|---|
| DAS local (max) W/kg | 1.576 | 1.557 | 1.574 | 1.561 | 0.0080 |
| DAS moyenné pour 1 g (max) W/kg | 0.899 | 0.903 | 0.905 | 0.908 | 0.0027 |
| DAS moyenné pour 10g (max) W/kg | 0.455 | 0.455 | 0.456 | 0.455 | 0.0004 |

L'efficacité de l'interface électronique peut facilement être comprise si l'on se réfère aux figures 2a, 2b et 3a, 3b.

Ces figures représentent des cartes obtenues respectivement sans et avec l'interface 3 de détection synchrone.

On comprend qu'au voisinage même du téléphone, il y a peu de différence entre les résultats obtenus avec et sans cette interface.

Par contre, plus en profondeur dans le corps fantôme, les cartes de champ apparaissent très différentes.

En particulier, sans l'interface de détection synchrone, les cartes de champ consistent principalement de bruit alors qu'elles sont très nettement dépourvues de tout bruit lorsque l'on utilise l'interface.

Ainsi, comme on l'aura compris, le dispositif proposé permet des mesures DAS précises et reproductibles.

On notera en particulier que des mesures avec une précision inférieure à 1mW/kg est particulièrement intéressante dans le cas de téléphones présentant des DAS très faibles, comme le cas de téléphones flip-flop ou de kits mains-libres, qui peuvent présenter des DAS aussi faibles que 10mW/kg.

Cette augmentation de la sensibilité peut être utilisée pour réduire le temps de mesure lui-même.

Des mesures de DAS avec des temps de mesure inférieurs à 2mn peuvent être envisagées.

L'ensemble des mesures alors nécessitées pour mettre en oeuvre la norme européenne EN50361 peut ainsi être réalisé en moins de 30mn.

Par ailleurs, on notera que le banc de mesure peut également être utilisé pour tester une source de champ électromagnétique a priori non modulé. Le banc comporte à cet effet des moyens pour la modulation en amplitude du champ électromagnétique généré par ladite source.

Il devient ainsi possible par exemple d'utiliser le banc de mesure proposé pour faire des mesures sur des téléphones portables de réseaux n'utilisant pas la modulation TDMA, voire même d'utiliser ce banc de mesures pour tester des antennes de téléphone portables, indépendamment de toute électronique de communication.

D'autres variantes de réalisation de l'invention sont bien entendu possibles.

Notamment, l'interface peut comporter un amplificateur d'isolation.

Un tel amplificateur est par exemple interposé entre l'amplificateur 4 et le module 5.

Il peut également être disposé en sortie du module 5 de détection synchrone.

On prévoit alors avantageusement, à la place de l'antenne 7 et du module 6, une fibre optique qui véhicule un signal optique modulé par un signal de référence, ainsi qu'un photodétecteur interposé entre ladite fibre et le module 5.

## Revendications

1. Dispositif pour la mesure de débits d'absorption spécifique sur un corps fantôme (1) qui simule le corps humain et qui est soumis à un champ électromagnétique, ce dispositif comportant une sonde (2) pour la mesure du champ électrique, un corps fantôme dans lequel ladite sonde est déplacée, des moyens de mesure (3-9) de la tension en sortie de ladite sonde,
**caractérisé en ce que** ces moyens de mesure (3-9) comportent des moyens de détection synchrone (5-7) qui mélangent un signal correspondant à la tension en sortie de ladite sonde avec un signal de référence qui est synchrone de la modulation du champ électromagnétique que l'on teste, les moyens de mesure comportant en outre des moyens (8, 9) pour mettre en oeuvre une mesure sur le signal redressé ainsi obtenu.

2. Dispositif selon la revendication 1, **caractérisé en ce qu'**il comporte des moyens de réception (7) du champ électromagnétique testé, ainsi que des moyens (6) pour la récupération d'un signal d'horloge synchronisé sur une enveloppe de modulation dudit champ électromagnétique.

3. Dispositif selon la revendication 1, **caractérisé en ce que** dans le cas où le champ électromagnétique est celui émis par un terminal téléphonique d'un réseau cellulaire à multiplexage temporel, le dispositif comporte des moyens de réception (7) du champ électromagnétique ainsi généré, ainsi que des moyens (6) pour la récupération d'un signal d'horloge synchronisé sur l'enveloppe de multiplexage temporel dudit champ électromagnétique.

4. Dispositif selon la revendication 1, **caractérisé en ce que** les moyens de détection synchrone comportent un émulateur de station de base de radiotéléphonie mobile pour la génération d'un signal de référence.

5. Dispositif selon l'une des revendications 1 à 4, **caractérisé en ce que** pour tester une source de champ électromagnétique a priori non modulée, il comporte des moyens pour la modulation en amplitude du champ électromagnétique généré par ladite source.

6. Dispositif selon l'une des revendications précédentes, **caractérisé en ce qu'**il comporte un amplificateur faible bruit (4) qui est interposé entre la sonde et les moyens de détection synchrones (5-7).

7. Dispositif selon l'une des revendications précédentes, **caractérisé en ce qu'**il comporte un convertisseur analogique/numérique (8) qui reçoit le signal en sortie des moyens de détection synchrone, le signal converti en sortie dudit convertisseur étant transmis à une unité de traitement et de gestion (9) qui relève et mémorise les valeurs des mesures et détermine en fonction des mesures qu'elle relève des cartographies de champ électrique dans le corps fantôme.

8. Dispositif selon l'une des revendications précédentes, **caractérisé en ce qu'**il comporte un amplificateur d'isolation.

9. Dispositif selon les revendications 6 et 8 prises en combinaison, **caractérisé en ce que** l'amplificateur d'isolation est interposé entre l'amplificateur faible bruit (4) et les moyens de détection synchrone (5-7).

10. Dispositif selon la revendication 8, **caractérisé en ce que** l'amplificateur d'isolation est disposé en sortie des moyens de détection synchron (5-7), le signal de référence étant transmise par une fibre optique sur un photodétecteur en entrée des moyens de détection synchrone (5-7).

11. Dispositif selon l'une des revendications précédentes, **caractérisé en ce que** le signal de référence est un signal rectangulaire symétrique.

## Patentansprüche

1. Vorrichtung zur Messung der spezifischen Absorptionsrate in einem Phantomkörper (1), der den menschlichen Körper simuliert und der einem elektromagnetischen Feld ausgesetzt ist, wobei diese Vorrichtung eine Sonde (2) zur Messung des elektrischen Feldes, einen Phantomkörper, in dem die Sonde verschoben wird und Meßmittel (3-9) zur Spannungsmessung am Ausgang der Sonde umfaßt,
**dadurch gekennzeichnet, daß** diese Meßmittel (3-9) Mittel zur synchronen Detektion (5-7) umfassen, die ein Signal, das der Spannung am Ausgang der Sonde entspricht, mit einem Referenzsignal das synchron mit der Modulation des geprüften elektromagnetischen Feldes ist, mischen, wobei die Meßmittel außerdem Mittel (8-9) zum Durchführen einer Messung am so erhaltenen gleichgerichteten Signal umfassen.

2. Vorrichtung nach Anspruch 1, **dadurch gekennzeichnet, daß** sie Empfangsmittel (7) zum Empfang des geprüften elektromagnetischen Feldes und Mittel (6) zur Rückgewinnung eines mit einer Modulationshüllkurve des elektromagnetischen Feldes synchronisierten Taktsignals umfaßt.

3. Vorrichtung nach Anspruch 1, **dadurch gekennzeichnet, daß** im Fall, daß das elektromagnetische Feld von einem Telefonendgerät eines zellularen Netzes mit zeitlichem Multiplexing abgestrahlt wird, die Vorrichtung Empfangsmittel (7) zum Empfang des so erzeugten elektromagnetischen Feldes und Mittel (6) zur Rückgewinnung eines mit der Hüllkurve des zeitlichen Multiplexing synchronisierten Taktsignals des elektromagnetischen Feldes umfaßt.

4. Vorrichtung nach Anspruch 1, **dadurch gekennzeichnet, daß** die Mittel zur synchronen Detektion einen Emulator einer Basisstation der mobilen drahtlosen Telefonie zum Erzeugen eines Referenzsignals umfassen.

5. Vorrichtung nach einem der Ansprüche 1 bis 4, **dadurch gekennzeichnet, daß** sie zum Prüfen einer Quelle eines nicht von vornherein modulierten elektromagnetischen Feldes Mittel zur Amplitudenmodulation des von der Quelle erzeugten elektromagnetischen Feldes umfaßt.

6. Vorrichtung nach einem der vorhergehenden Ansprüche, **dadurch gekennzeichnet, daß** sie einen rauscharmen Verstärker (4) umfaßt, der zwischen die Sonde und die Mittel zur synchronen Detektion (5-7) geschaltet ist.

7. Vorrichtung nach einem der vorhergehenden Ansprüche, **dadurch gekennzeichnet, daß** sie einen Analog/Digital-Wandler (8) umfaßt, der die Signale am Ausgang der Mittel zur synchronen Detektion erhält, wobei das umgewandelte Signal am Ausgang des Wandlers an eine Verarbeitungs- und Verwaltungseinheit (9) übertragen wird, die die Meßwerte aufnimmt und speichert und in Abhängigkeit der von ihr aufgenommenen Meßwerte Kartierungen des elektrischen Feldes im Phantomkörper bestimmt.

8. Vorrichtung nach einem der vorhergehenden Ansprüche, **dadurch gekennzeichnet, daß** sie einen Isolationsverstärker umfaßt.

9. Vorrichtung nach Anspruch 6 in Verbindung mit Anspruch 8, **dadurch gekennzeichnet, daß** der Isolationsverstärker zwischen den rauscharmen Verstärker (4) und die Mittel zur synchronen Detektion (5-7) geschaltet ist.

10. Vorrichtung nach Anspruch 8, **dadurch gekennzeichnet, daß** der Isolationsverstärker am Ausgang der Mittel zur synchronen Detektion (5-7) angeordnet ist, wobei das Referenzsignal durch eine optische Faser auf einen Photodetektor am Eingang der Mittel zur synchronen Detektion (5-7) geleitet wird.

11. Vorrichtung nach einem der vorhergehenden Ansprüche, **dadurch gekennzeichnet, daß** das Referenzsignal ein symmetrisches Rechtecksignal ist.

## Claims

1. Device for measuring specific absorption rates in a phantom body (1) that simulates the human body and is subjected to an electromagnetic field, this device comprising a probe (2) for measuring the electric field, in which phantom body the said probe is moved, and means (3-9) for measuring the voltage output by the said probe,
**characterized in that** these measurement means (3-9) comprise synchronous detection means (5-7) that mix a signal corresponding to the voltage output by the said probe with a reference signal that is synchronous with the modulation of the electromagnetic field that is tested, the measurement means furthermore including means (8, 9) for carrying out a measurement on the rectified signal thus obtained.

2. Device according to Claim 1, **characterized in that** it includes means (7) for receiving the electromagnetic field tested, and also means (6) for recovering a clock signal synchronized to a modulation envelope for the said electromagnetic field.

3. Device according to Claim 1, **characterized in that**, if the electromagnetic field is that emitted by a telephone terminal of a cellular network with temporal multiplexing, the device includes means (7) for receiving the electromagnetic field thus generated, and also means (6) for recovering a clock signal synchronized on the temporal multiplexing envelope for the said electromagnetic field.

4. Device according to Claim 1, **characterized in that** the synchronous detection means comprise a mobile radio telephony base station for generating a reference signal.

5. Device according to one of Claims 1 to 4, **characterized in that**, for testing an electromagnetic field source that is a priori not modulated, it includes means for amplitude-modulating the electromagnetic field generated by the said source.

6. Device according to one of the preceding claims, **characterized in that** it includes a low-noise amplifier (4) that is interposed between the probe and the synchronous detection means (5-7).

7. Device according to one of the preceding claims, **characterized in that** it includes an analogue/digital converter (8) that receives the signal output by the synchronous detection means, the signal converted into the output of the said converter being transmitted to a processing and management unit (9) which records and stores the values of the measurements and determines, as a function of the measurements that it records, electric field mappings in the phantom body.

8. Device according to one of the preceding claims, **characterized in that** it includes an isolating amplifier.

9. Device according to Claims 6 and 8 taken in combination, **characterized in that** the isolating amplifier is interposed between the low-noise amplifier (4) and the synchronous detection means (5-7).

10. Device according to Claim 8, **characterized in that** the isolating amplifier is placed on the output side of the synchronous detection means (5-7), the reference signal being transmitted by an optical fibre to a photodetector on the input side of the synchronous detection means (5-7).

11. Device according to one of the preceding claims, **characterized in that** the reference signal is a symmetrical rectangular signal.
